# EUROPÄISCHE PATENTANMELDUNG

(11) **EP 1 075 010 A2**
(43) Veröffentlichungstag der Anmeldung: **07.02.2001**
(21) Anmeldenummer: 00114739.6
(22) Anmeldetag: 08.07.2000
(51) Int. Cl.: H01H 37/74, H01H 37/76

(54) **Halbleiterschalter**

(30) Priorität: 31.07.1999 DE 19936112
(71) Anmelder: Mannesmann VDO Aktiengesellschaft, 60388 Frankfurt am Main (DE)
(72) Erfinder: Berberich, Reinhold, 60439 Frankfurt (DE); Bay, Wolfgang, 65936 Frankfurt (DE)
(74) Vertreter: Klein, Thomas, Dipl.-Ing.

(57) **Zusammenfassung**

Bei einem Halbleiterelement, insbesondere zum Schalten einer elektrischen Verbindung, ist eine bei Erwärmung sich stark ausdehnende Substanz derart an dem Element angeordnet, daß im Falle einer Überwärmung des Elements durch die sich ausdehnende Substanz die elektrischen Zuleitungen des Elements abgetrennt werden oder durch Schmelzen eines die Zuleitungen bildenden niedrigschmelzenden leitenden Materials aufgetrennt werden.

## Beschreibung

Die Erfindung betrifft ein Halbleiterelement, insbesondere zum Schalten einer elektrischen Verbindung.

Derartige Elemente werden beispielsweise in der Kraftfahrzeugtechnik zum vollelektronischen Schalten des Bordstromnetzes verwendet. Die verwendeten Halbleiterschalter können im Falle einer Überlastung durchlegieren und dadurch in einen undefiniert niederohmigen Zustand übergehen. Die Halbleiterschalter und gegebenenfalls auch angeschlossene Geräte und elektronische Schaltungen können daraufhin Fehlfunktionen aufweisen, überhitzt werden und in Brand geraten.

Vorhandene Schmelzsicherungen können in dem beschriebenen Fall nicht sicher helfen, da deren zum Abschalten erforderlichen Ströme nicht in jedem Fehlerfall erreicht werden. Auch im Halbleiter integrierte Überstromabschaltungen können nur funktionieren, solange der Halbleiterchip selbst noch einwandfrei funktioniert, was in der Praxis ebenfalls nicht für alle Fehlerfälle garantiert werden kann.

Aufgabe der vorliegenden Erfindung ist es somit, ein Halbleiterelement anzugeben, welches gegen mögliche Folgen einer Überlastung gesichert ist. Das Element soll einfach und preiswert in großen Stückzahlen herstellbar sein.

Diese Aufgabe wird erfindungsgemäß dadurch gelöst, daß eine bei Erwärmung sich stark ausdehnende Substanz derart an dem Element angeordnet ist, daß im Falle einer Überwärmung des Elements durch die sich ausdehnende Substanz die elektrischen Zuleitungen des Elements abgetrennt werden. Im Falle einer Überlastung heizt sich ein erfindungsgemäßes Halbleiterelement aufgrund seines endlichen elektrischen Widerstands zunehmend auf. Diese Überhitzung nutzt die Erfindung für die Auslösung des Sicherungselementes. Die elektrischen Zuleitungen zu dem Element werden, durch geeignet angeordnete Portionen der Substanz getrennt, vorzugsweise abgerissen. Ferner lassen sich durch den entstehenden Druck der sich ausdehnenden Substanz Bauteile auseinandertreiben und für die Auftrennung der elektrischen Verbindung nutzen.

Bei einer ersten Ausgestaltung der Erfindung ist vorgesehen, daß die Substanz eine bei einer vorgegebenen Grenztemperatur schnell verdampfende Substanz ist.

Eine weitere Ausgestaltung der Erfindung sieht vor, daß die Substanz eine bei einer vorgegebenen Grenztemperatur aufquellende Substanz ist.

Bei einer anderen Ausgestaltung der Erfindung ist vorgesehen, daß die Substanz sich bei Überschreiten einer vorgegebenen Grenztemperatur explosionsartig ausdehnt und daß die Substanz derart angeordnet ist, daß die Zuleitungen infolge der Explosion abgetrennt werden. Hierfür kann ein pyrotechnisches Material, ähnlich dem in Airbags verwendeten, eingesetzt werden.

Eine wirkungsvolle Auftrennung der elektrischen Zuleitungen läßt sich dadurch erreichen, daß die Substanz derart zwischen dem Halbleiterelement und einem weiteren Teil angeordnet ist, daß das weitere Teil und das Halbleiterelement durch die sich ausdehnende Substanz auseinandergetrieben werden und daß die an dem Halbleiterelement angebrachten Zuleitungen derart geführt sind, daß sie durch das sich wegbewegende weitere Teil abgerissen werden. Dabei kann insbesondere vorgesehen sein, daß das Halbleiterelement mit einer Schicht der Substanz überzogen ist, daß diese Schicht durch das weitere Teil abgedeckt ist und daß die an dem Element angebrachten Zuleitungen durch die Schicht hindurchlaufen und fest mit dem weiteren Teil verbunden sind. Das weitere Teil kann hierbei eine Deckschicht aus Kunststoff sein, in welche die Zuleitungsdrähte eingegossen sind. Durch die Volumenvergrößerung der Substanz hebt die Deckschicht von dem Halbleiterelement ab, und die Zuleitungsdrähte werden abgerissen.

Eine andere Lösung des Problems läßt sich dadurch erreichen, daß die elektrische Verbindung zu dem Element über ein niedrigschmelzendes leitendes Material erfolgt, welches derart an dem Element angeordnet ist, daß die Verbindung im Falle einer Überwärmung des Elements durch Schmelzen des Materials getrennt wird. Die Wärmezufuhr erfolgt dabei aus dem überhitzten Halbleiterelement selbst. Eine herkömmliche Schmelzsicherung ist dazu nicht einsetzbar, da die auftretenden Ströme die üblicherweise im System vorkommenden Stromstärken nicht überschreiten.

Ausführungsbeispiele der Erfindung sind in der Zeichnung anhand mehrerer Figuren dargestellt und in der nachfolgenden Beschreibung näher erläutert. Es zeigt:
- Fig. 1: ein mit einer explosiven Ladung versehenes Halbleiterelement,
- Fig. 2: ein mit einer Schmelzsicherung versehenes Halbleiterelement und
- Fig. 3: ein mit einer niedrigverdampfenden Substanz und einer festen Deckschicht versehenes Halbleiterelement.

Gleiche Teile sind in den Figuren mit gleichen Bezugszeichen versehen.

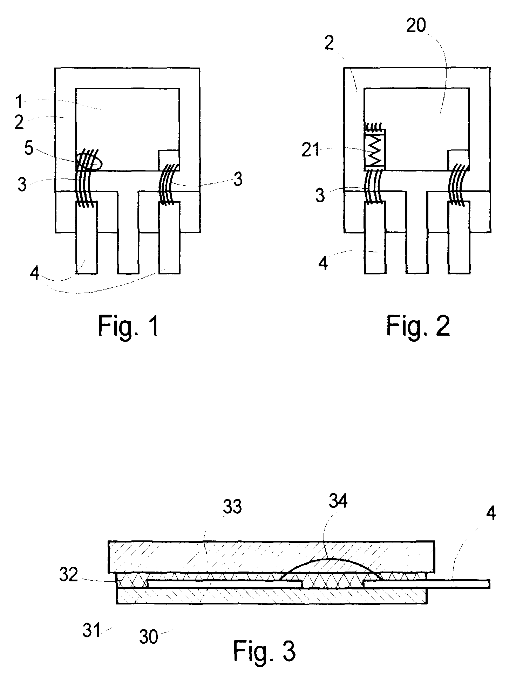

Bei dem in Fig. 1 gezeigten Element 1 handelt es sich um einen mit einer erfindungsgemäßen Überlastsicherung versehenen Halbleiterschalter. Das Element 1 ist auf einem Träger 2 montiert und über Drähte 3 mit den elektrischen Anschlüssen 4 verbunden. Unterhalb der Drähte 3 des einen Anschlusses ist eine explosive Substanz 5 angeordnet, die im Falle einer Überhitzung des Elements 1 anspricht und die Drähte 3 abreißt, so daß nachgeschaltete Bauteile keinen Schaden nehmen.

Fig. 2 zeigt ein Element 20, das mit einer Schmelzsicherung 21 gesichert ist. Im Falle einer Überhitzung des Elements 20 schmilzt der Sicherungsdraht 21 durch die Wärme des Elements 20 und unterbricht somit die Stromzufuhr.

Fig. 3 zeigt schließlich noch ein Halbleiterelement 30 in Seitenansicht. Das Element 30 ist auf einem Träger 31 aufgebracht. Darüber liegt eine Schicht 32 einer bei Überhitzung des Elements 30 verdampfenden Substanz. Diese Schicht 32 ist mit einer als Abdeckung dienenden festen Deckschicht 33 versehen. Die Anschlußdrähte 34 sind in einem Bogen geführt und in die Deckschicht 33 eingegossen. Im Falle einer Überhitzung des Elements 30 verdampft die Substanz 32 und drückt die Deckschicht 33 nach oben, wodurch die Anschlußdrähte 34 abreißen.

## Patentansprüche

1. Halbleiterelement, insbesondere zum Schalten einer elektrischen Verbindung, dadurch gekennzeichnet, daß eine bei Erwärmung sich stark ausdehnende Substanz (5, 32) derart an dem Element (1, 20, 30) angeordnet ist, daß im Falle einer Überwärmung des Elements (1, 20, 30) durch die sich ausdehnende Substanz (5,32) die elektrischen Zuleitungen (3, 34) des Elements abgetrennt werden.

2. Halbleiterelement nach Anspruch 1, dadurch gekennzeichnet, daß die Substanz (32) eine bei einer vorgegebenen Grenztemperatur schnell verdampfende Substanz ist.

3. Halbleiterelement nach Anspruch 1, dadurch gekennzeichnet, daß die Substanz eine bei einer vorgegebenen Grenztemperatur aufquellende Substanz (5) ist.

4. Halbleiterelement nach Anspruch 1, dadurch gekennzeichnet, daß die Substanz sich bei Überschreiten einer vorgegebenen Grenztemperatur explosionsartig (5) ausdehnt und daß die Substanz derart angeordnet ist, daß die Zuleitungen (3) infolge der Explosion abgetrennt werden.

5. Halbleiterelement nach einem der vorhergehenden Ansprüche, dadurch gekennzeichnet, daß die Substanz derart zwischen dem Halbleiterelement (30) und einem weiteren Teil (33) angeordnet ist, daß das weitere Teil (33) und das Halbleiterelement (30) durch die sich ausdehnende Substanz (32) auseinandergetrieben werden und daß die an dem Halbleiterelement (30) angebrachten Zuleitungen (34) derart geführt sind, daß sie durch das sich wegbewegende weitere Teil (33) abgerissen werden.

6. Halbleiterelement nach Anspruch 5, dadurch gekennzeichnet, daß das Halbleiterelement mit einer Schicht (32) der Substanz überzogen ist, daß diese Schicht durch das weitere Teil (33) abgedeckt ist und daß die an dem Element angebrachten Zuleitungen (34) durch die Schicht (32) hindurchlaufen und fest mit dem weiteren Teil (33) verbunden sind.

7. Halbleiterelement, insbesondere zum Schalten einer elektrischen Verbindung, dadurch gekennzeichnet, daß die elektrische Verbindung zu dem Element (20) über ein niedrigschmelzendes leitendes Material (21) erfolgt, welches derart an dem Element (20) angeordnet ist, daß die Verbindung im Falle einer Überwärmung des Elements (29) durch Schmelzen des Materials (21) getrennt wird.
